# EUROPEAN PATENT APPLICATION

(11) **EP 1 318 544 A1**
(43) Date of publication of application: **11.06.2003**
(21) Application number: 01830748.8
(22) Date of filing: 06.12.2001
(51) Int. Cl.: H01L 23/433, H01L 21/56

(54) **Method for manufacturing semiconductor device packages**

(71) Applicant: STMicroelectronics S.r.l., 20041 Agrate Brianza (Milano) (IT)
(72) Inventor: Mazzola, Mauro, 24040 Calvenzano (Bergamo) (IT); Poinelli, Renato, 23880 Casatenovo (Lecco) (IT)
(74) Representative: Botti, Mario

(57) **Abstract**

A method of molding a plastics package (20) for encapsulating a semiconductor integrated electronic device (10) supported on a conductive lead frame (50), which lead frame has a plurality of peripheral leads (60) integrally formed therewith and is coupled thermally to a heat sink element (30), said method comprising the step of:
- injecting a molten plastics material into a mold (90) containing said device (10); wherein said heat sink element (30) has at least one extension (70) extending in the direction toward a corner of the plastics package (20); and
- the molten plastics material is injected through a gate (11) provided on one side of said extension (70) to extend parallel thereto.

## Description

### Field of Application

The present invention relates to a method for manufacturing plastics packages for semiconductor devices.

The invention specifically relates to a method for manufacturing by molding a plastics package adapted to encapsulate an electronic device that is integrated in a semiconductor and supported on a conductive lead frame, wherein the lead frame is provided with a plurality of peripherally arranged leads integrally formed therewith, and is coupled thermally to a heat sink element, which method comprises the step of:
- injecting a molten plastics material into a mold containing said device.

The invention also relates to a mold for molding a plastics package adapted to encapsulate an electronic device that is integrated in a semiconductor and supported on a lead frame, wherein the lead frame is provided with a plurality of peripherally arranged leads integrally formed therewith, and is coupled thermally to a heat sink element.

The invention further relates to a plastics package for an electronic device that is integrated in a semiconductor and supported on a conductive lead frame, wherein the lead frame is provided with a plurality of peripherally arranged leads integrally formed therewith, and is coupled thermally to a heat sink element.

The invention relates, particularly but not exclusively, to a method for manufacturing plastics packages for semiconductor devices that incorporate partially exposed heat sink elements, and this description will make reference to this field of application for convenience of illustration.

### Prior Art

As is well known, semiconductor electronic devices comprise an electronic circuit formed in a small plate of a semiconductor material, known as the "die", having a surface area of a few square millimeters. The electronic circuit is typically integrated to the die monolithically. The die is then enclosed in a case or package for heat and mechanical protection. Plastics packages will be specifically considered here.

Such devices require suitable support and electric interconnection arrangements for their electric connection to an external circuit. For the purpose, a lead frame is cut from thin metal plate to include a plurality of narrow strips forming electric connectors or leads having one end connected electrically to the integrated circuit by means of conductive wires, the latter being soldered between each end and corresponding terminations of the integrated circuit. The other or free ends are led out of the plastics package to provide so-called electric connection pins for the device.

Since certain new generation devices may require over 100 leads for as many pins, the metal strips have to be made very thin and, therefore, are easily distorted. To obviate the problem, a the dam bar is provided to link the frame leads together.

The power integrated circuits discussed hereinafter are commonly referred to as "power packages", and are apt to release relatively large amounts of heat. The term denotes a device that is adapted to dissipate heat.

In this case, the die would be coupled thermally to a heat sink element for transferring the heat generated during its operation to the outside environment.

The heat sink element is made of metal, or another good heat conductor, in the form of a cylinder or a flattened parallelepiped having a much larger mass than the electronic device that is the die itself.

As is typical in a power package, the heat sink element has only one of its major surfaces exposed, the other major surface and all the lateral surfaces of the element being isolated that is covered under the material from which the plastics package is formed.

In some devices, the heat sink element has at least one of its sides also exposed laterally from the plastics package.

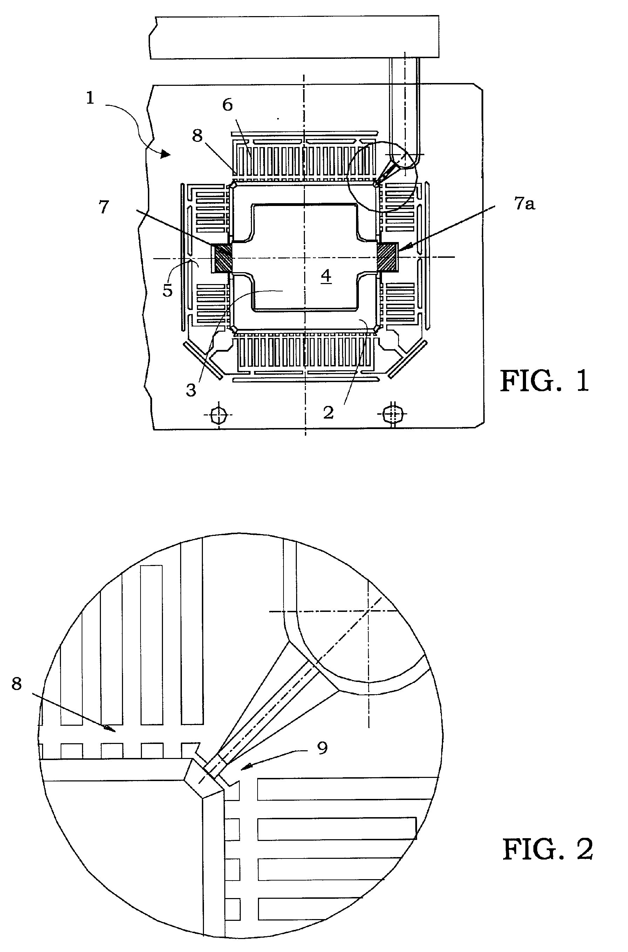

Figure 1 is a bottom view of an electronic device 1 after the plastics package 2 has been molded around it. The plastics package 2 encapsulated a heat sink element 3 so as to only leave the bottom major surface 4 of the latter exposed, this surface being flush with the package underside. A frame 5 is then mounted on the opposite surface of the heat sink element 3 from the surface 4, and affixed there as by riveting or soldering. The frame is partly embedded in the plastics package 2 such that the ends of leads, denoted by 6, project outside of the plastics package 2. A dam bar 8 is provided to link the leads together.

In this prior device, the heat sink element has two extensions 7, whose ends are projected out through opposite sides of the plastics package.

In particular, the extensions 7 locate in this device type centrally in two opposed sides of the frame 5. No leads of the frame 5 can be formed correspondingly with these extensions 7.

The aspects of the present invention can be better understood by briefly reviewing the standard process steps for molding a conventional plastics package with an exposed heat sink.

A tape of integrated circuits, complete with their heat sinks, is introduced into a mold having cavities aligned to the individual devices for molding their respective plastics packages. Each cavity is injected a molten electrically insulative material at a high temperature, which material is typically a synthetic resin, e.g. an epoxy resin, intended for forming the plastics package.

To arrange for the heat sink element 3 to have an exposed surface, the mold is formed at said peripheral portions or extensions with cavities, in which plastics blocks or "tips" 7a are molded. These tips 7a will be abutting on the exposed portions of the extensions 7 in the finished package.

The molding process itself comprises injecting the resin into the cavity through a gate 9, shown best in Figure 2, to form the plastics package together with the plastics tips 7a. In the instance of the devices shown in Figure 2, the injection gate would be provided in the mold at one corner of the device.

The molding process is then continued through steps to be carried out inside the mold, namely: melting the plastics material, expanding the melt inside the mold, and solidifying.

After an initial cooling step, followed by thermal curing processes to thoroughly polymerize the resin, the plastics package is completely formed, and the series of plastics packages ready for removal from the mold.

The plastics tips 7a are then removed from the finished plastics package to uncover the portions of the extensions 7 that require to be exposed.

Although advantageous on several aspects, this prior method has several drawbacks. The new power devices require a larger number of pins 6 for connection to the outside environment.

Thus, the lateral regions of the plastics package must be left unobstructed, such that the leads can be provided all around the peripheral surface of the package.

The underlying technical problem of this invention is to provide a method for manufacturing plastics packages for electronic devices having exposed heat sinks with suitable features to overcome the limitations of prior manufacturing methods.

### Summary of the Invention

The solvent idea on which this invention is based on is to provide a method of manufacturing a protective case adapted to encapsulate a power device having an exposed heat sink and a large number of leads, wherein the resin injection space is optimized by a modified frame structure.

Based on this principle, the technical problem is solved by a method as previously indicated and as defined in the characterizing part of Claim 1.

The problem is also solved by a mold as previously indicated and as defined in the characterizing part of Claim 5.

The problem is further solved by a plastics package as previously indicated and as defined in the characterizing part of Claim 7.

The features and advantages of the method according to this invention will become apparent from the following detailed description of an embodiment thereof, given by way of non-limitative example with reference to the accompanying drawings.

### Brief Description of the Drawings

In the drawings:
Figure 1 is a bottom plan view of an electronic device, during the molding step for forming the plastics package using a conventional molding technique;
Figure 2 is an enlarged view of a portion of the electronic device shown in Figure 1;
Figure 3 is a bottom plan view of an electronic device, during the molding step for forming the plastics package by the molding process of this invention;
Figure 4 is an enlarged view of a portion of the electronic device shown in Figure 3;
Figure 5 is a sectional view of the device shown in Figure 4, taken along line V-V; and
Figure 6 is a sectional view of the device shown in Figure 4, taken along line VI-VI.

### Detailed Description

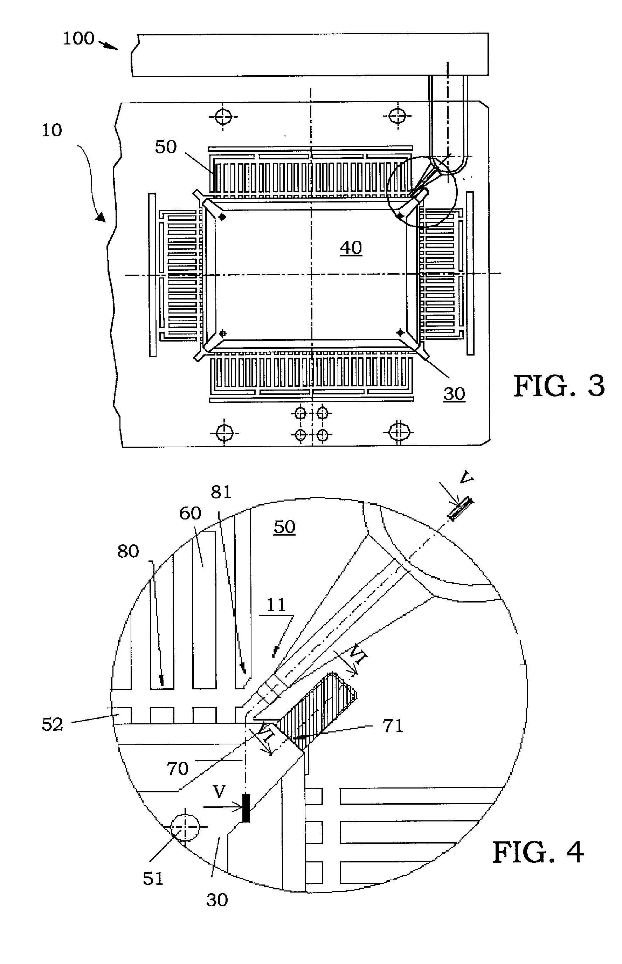

A method for manufacturing a plastics package according to this invention will now be described with reference to Figures 3 to 6.

In particular, Figures 3 and 4 are bottom plan views of an electronic device 10 after the plastics package 20 is molded. Embedded in this plastics package 20 is a heat sink element 30, which is disposed to only have its bottom major surface 40 exposed flush with the package underside.

A lead frame 50 is then attached to the heat sink element 30 on the opposite end from the surface 40, using such fastening means as rivets or solder 51. The frame 50 is partly embedded in the plastics package 20 such that the ends of leads, shown at 60, project outside of the plastics package 20. A dam bar 80 is provided to link the leads 60 together.

In particular, the lead frame 50 includes an outer frame 52 surrounding a die, not shown. The outer frame 52 carries four sets of inward leads connected to the die, and four sets of outward leads for connection to outer terminals, the outward set being connected to the inward set by the dam bar 80. The dam bar 80 provides support for holding the leads in place through the device assembling process.

The heat sink element 30, which may be rectangular in shape, has four extensions 70 extending substantially in continuation of the four corners of the plastics package 20. The extensions 70 have each an end surface 71 rising from the plastics package 20.

The method of molding plastics packages according to this invention will now be described.

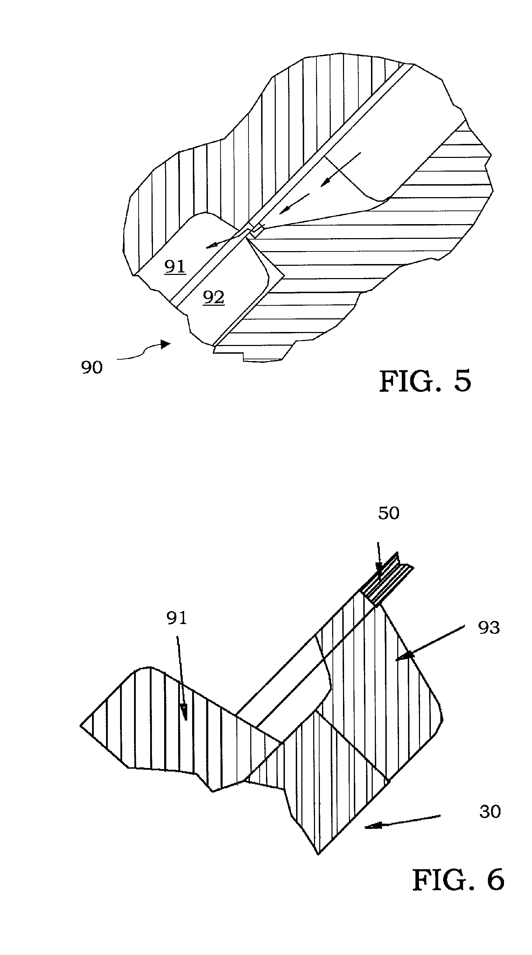

In particular, Figure 5 is a vertical cross-section view of a mold defining a single cavity, although in conventional molding processes the mold would include a number of adjacent cavities for molding plural packages simultaneously.

A resin injection mold is denoted generally by 90. In the embodiment shown in Figures 5 and 6, the mold comprises a top half mold, denoted by 91, and a bottom half mold 92. The mold halves are provided with recesses, facing each other with the mold closed, to define a single molding cavity into which the resin will be injected.

The plastics package 20 for encapsulating the frame 50 together with the die and the heat sink element 30, is to allow a major surface 40 of the heat sink element 30 and the end surfaces 71 of the extensions 70 to become exposed.

For the purpose, the heat sink element 30 should be in contact with the bottom half mold 92. In addition, the bottom half mold 92 should be formed with cavities 93 at the locations of the extensions 70. These cavities 93 should locate at the frame corners.

After the frame 50 is positioned in the mold and the mold closed, a filler, such as an epoxy resin, is injected into the mold 90.

The resin is injected in a molten state through a runner 100 formed in the bottom half mold 92, the runner narrowing in the direction toward an inlet 11 that forms the mold gate.

According to the invention, the frame 50 is designed to have the gate 11 located adjacent to one of the molding cavities 93 formed at the locations of the extensions 70 of the heat sink element 30. In particular, the gate 11 and the runner for conveying the resin into the molding cavity locate between one cavity 93 and an adjacent lead 60. For the purpose, the dam bar 80 is formed with a lead-in notch 81 to admit the resin into the mold 90. In particular, the dam bar 80 is cut to slope to one side of the frame 50.

In other words, the centerline of the gate 11 lies substantially parallel to a diagonal line of the frame, but offset therefrom.

Its position is selected to enable the resin to fill even the remotest regions of the mold cavity from the gate.

Advantageously in this invention, the resin inflow to the mold goes through the frame between the cavities 93 and the adjacent leads.

Summarizing, the method of this invention achieves the following:
- fabrication of power packages with a large number of pins and heat sinks located at the corners of the plastics package;
- reduced risk of fractures occurring in the corner areas of the plastics package;
- simple frame design; and
- simple molding insert design.

## Claims

1. A method for manufacturing by molding a plastics package (20) for encapsulating a semiconductor integrated electronic device (10) supported on a conductive lead frame (50), said lead frame having a plurality of peripheral leads (60) integrally formed therewith and being coupled thermally to a heat sink element (30), said method comprising the step of:
- injecting a molten plastics material into a mold (90) containing said device (10);
**characterized in that**:
- said heat sink element (30) has at least one extension (70) extending in the direction toward a corner of the plastics package (20); and
- the molten plastics material is injected through a gate (11) provided on one side of said extension (70) to locate parallel to the latter.

2. A method according to Claim 1, wherein the leads (60) are held together on the frame (5) by a dam bar (80), **characterized in that** said dam bar (80) is formed with a go-through notch (81) near said extension (70).

3. A method for manufacturing a plastics package according to Claim 2, **characterized in that** said notch (81) slopes to one side of said frame (30).

4. A method for manufacturing a plastics package according to Claim 3, **characterized in that** the plastics material is injected through said gate (11) and a runner (100) formed with a constriction at said gate (11).

5. A mold (90) for manufacturing a plastics package (20) intended to encapsulate a semiconductor integrated electronic device (10) supported on a lead frame (50), said lead frame having a plurality of peripheral leads (60) integrally formed therewith and being coupled thermally to a heat sink element (30);
**characterized in that** it comprises:
- at least one cavity (93) at the location of at least one extension (70) of said electronic device (10) extending in the direction toward one corner of the plastics package (20); and
- a gate (11) located on one side of said extension (70) for injecting a molten plastics material into said mold (90).

6. A mold for manufacturing a plastics package according to Claim 5, **characterized in that** said gate (11) connects to a runner formed with a constriction at said gate (11).

7. A plastics package (20) for a semiconductor integrated electronic device (10) supported on a lead frame (50), said lead frame having a plurality of peripheral leads (60) integrally formed therewith and being coupled thermally to a heat sink element (30); **characterized in that** said heat sink element (30) has at least one extension (70) extending in the direction toward one corner of the plastics package (20), and that said leads (60) are held together on the frame (50) by a dam bar (80) formed with a notch (81) near said extension (70).

8. A plastics package (20) for an electronic device (10) according to Claim 7, **characterized in that** said at least one extension (70) has an end surface (71) rising from said package (20).
